# EUROPÄISCHE PATENTANMELDUNG

(11) **EP 4 131 332 A1**
(43) Veröffentlichungstag der Anmeldung: **08.02.2023**
(21) Anmeldenummer: 22188642.7
(22) Anmeldetag: 04.08.2022
(51) Int. Cl.: H01J 37/34, C23C 14/35

(54) **MEHRFACH-SPUTTERTARGET**

(30) Priorität: 04.08.2021 DE 102021120332
(71) Anmelder: FHR Anlagenbau GmbH, 01458 Ottendorf-Okrilla (DE)
(72) Erfinder: Kleinhempel, Ronny, 09328 Lunzenau (DE); Bergk, Beate, 01099 Dresden (DE)
(74) Vertreter: Lippert Stachow Patentanwälte Rechtsanwälte Partnerschaft mbB

(57) **Zusammenfassung**

Die Erfindung betrifft ein Mehrfach-Sputtertarget für Magnetronanordnungen mit Rohrmagnetrons, zum Beschichten von ruhenden, oder längs oder auf einer Kreisbahn durch eine Vakuumkammer transportierten Substraten, wobei das Rohrmagnetron in einem Endblock, oder einer anderweitigen Antriebseinheit, gelagert ist und wobei sich in dem Rohrmagnetron eine Magnetbar befindet. Durch die Erfindung soll ein Mehrfach-Sputtertarget geschaffen werden, mit dem längs oder auf einer Kreisbahn durch eine Vakuumkammer transportierte Substrate durch Magnetron-Sputtern mit geringem Aufwand mit einer auswählbaren Vielzahl von Materialien beschichtet werden können. Erreicht wird das dadurch, dass mindestens ein polygonales Trägerrohr (1) mit einem eckigen Querschnitt vorgesehen ist, das eine Mehrzahl von längs verlaufenden Außenflächen (3) zur Aufnahme von Targets (2) aufweist, dass sich in dem mindestens einen polygonalen Trägerrohr (1) ein Freiraum (5) befindet, der sich längs durch dieses erstreckt und in dem sich eine Magnetbar (4) zur Ausbildung von Plasmawolken (6) außerhalb des polygonalen Trägerrohres (1) in einer Arbeitsposition vor einem durch Drehen des polygonalen Trägerrohres auswählbaren Target (2) befindet und dass sich das bewegte oder ruhende Substrat (7) in einem vorgegebenen Abstand vor den Plasmawolken (6) befindet.

## Beschreibung

Die Erfindung betrifft ein Mehrfach-Sputtertarget für Magnetronanordnungen mit Rohrmagnetrons, zum Beschichten von ruhenden, oder längs oder auf einer Kreisbahn durch eine Vakuumkammer transportierten Substraten, wobei das Rohrmagnetron in einem Endblock, oder einer anderweitigen Antriebseinheit, gelagert ist und wobei sich in dem Rohrmagnetron eine Magnetbar befindet.

Allgemein bekannt sind Rohrmagnetrons, in dem sich eine räumlich feststehende Magnetbar befindet, die in einem Magnetron-Endblock einseitig oder zusätzlich in einem Gegenlager drehbar gelagert sind, der Magnetron-Endblock stellt einen Drehantrieb für das Rohrmagnetron und andererseits das nötige Kühlwasser sowie die Energieversorgung für das Magnetron zur Verfügung.

Aus der DE 10 2008 048 785 A1 geht eine solche Magnetronanordnung mit einem drehbaren Rohrmagnetron hervor. Der Endblock enthält einerseits einen Drehantrieb für das Rohrtarget und andererseits die notwendige Energiezuführung zum Zünden und Aufrechterhalten eines Plasmas zwischen dem Rohrmagnetron und dem zu beschichtenden Substrat. Das Rohrtarget besteht aus einem Trägerrohr und einem außen aufgebrachten Targetmaterial.

Mit einer solchen Magnetronanordnung können in einer Vakuumkammer großflächige Substrate beschichtet werden, die an dem Magnetron vorbei bewegt werden. Von besonderem Nachteil ist der Umstand, dass bei jedem Durchgang jeweils nur ein Material gesputtert werden kann und dass zum Sputtern anderer Materialien nach dem Belüften der Vakuumkammer ein anderes Rohrtaget montiert und die Vakuumkammer wieder entlüftet werden muss.

Ein Ausweg wäre die Anordnung mehrerer Rohrmagnetrons hintereinander in einer Vakuumkammer, was natürlich den Aufwand und die Kosten beträchtlich infolge der dann größeren Anlage erhöhen würde.

Ein weiteres Rohrmagnetron mit innen liegendem Magnetsystem geht auch aus der WO 2003/081 634 A2 hervor. Das Rohrmagnetron besteht hauptsächlich aus einem Targetträger in Form eines Rohres und einem äußeren Target, bestehend aus einer Vielzahl von ebenen Targetplatten, die auf dem rohrförmigen Targetträger tangential aufliegen, so dass sich eine lückenlose polygone Targetoberfläche ergibt.

Um hier eine Verbesserung zu erreichen, d.h. um nacheinander verschiedene Materialien absputtern zu können, sind kommerziell verfügbare "Targetrevolver" verfügbar geworden, bei denen um eine zentrale Achse mehrere winkelversetzte vollständige Magnetrons verbaut sind, die infolge der Erzeugung des notwendigen Magnetfeldes, der Anoden, der notwendigen Kühlung, sowie der Stromanschlüsse einen relativ großen Bauraum benötigen und infolge des aufwändigen Aufbaus recht teuer sind.

Um einen Sputtervorgang ausführen zu können, muss der "Targetrevolver" in Abhängigkeit von der Anzahl der verbauten Magnetrons in festen Winkelschritten gedreht werden, bis sich das gewünschte Magnetron gegenüber dem zu beschichtenden Substrat befindet, so dass zwischen dem Magnetron und dem Substrat ein Sputterplasma gezündet werden kann. Der Vorteil eines solchen "Targetrevolvers" ist darin zu sehen, dass in der gleichen Vorrichtung unterschiedliche Materialien abgesputtert werden können.

Der Erfindung liegt nun die Aufgabe zugrunde, ein Mehrfach-Sputtertarget zu schaffen, mit dem längs oder auf einer Kreisbahn durch eine Vakuumkammer transportierte Substrate durch Magnetron-Sputtern nacheinander mit geringem Aufwand mit einer auswählbaren Vielzahl von Materialien beschichtet werden können.

Erreicht wird das bei einem Mehrfach-Sputtertarget der eingangs genannten Art dadurch, dass mindestens ein polygonales Trägerrohr mit einem eckigen Querschnitt vorgesehen ist, das eine Mehrzahl von längs verlaufenden Außenflächen zur Aufnahme von Targets aufweist, derart, dass sich in dem mindestens einen polygonalen Trägerrohr ein Freiraum befindet, der sich längs durch dieses erstreckt und in dem sich eine Magnetbar zur Ausbildung von Plasmawolken außerhalb des polygonalen Trägerrohres in einer Arbeitsposition vor einem durch Drehen des polygonalen Trägerrohres auswählbaren Target befindet und dass sich das bewegte oder ruhende Substrat in einem vorgegebenen Abstand vor den Plasmawolken befindet.

In Fortführung der Erfindung befindet sich auf jeder der Außenflächen des Trägerrohres ein Target aus gleichen oder bevorzugt aus unterschiedlichen Materialien. Letzteres ermöglicht das aufeinanderfolgende Sputtern von unterschiedlichen Materialien auf das gleiche Substrat, oder auf die gleichen Substrate einer Charge, ohne Vakuumunterbrechung.

Die Targets sind auf den Außenflächen bevorzugt durch Bonden oder anderweitig mechanisch befestigt.

In einer weiteren Ausgestaltung der Erfindung weist das polygonale Trägerrohr einen dreieckigen, viereckigen, fünfeckigen, sechseckigen, siebeneckigen oder achteckigen Querschnitt auf, so dass eine entsprechende Anzahl von Targets auf dem polygonalen Trägerrohr untergebracht werden kann.

Schließlich ist das polygonale Trägerrohr in Winkelschritten drehbar, derart, dass die Targets einzeln zwischen der Magnetbar und den vor dieser befindlichen Plasmawolken positionierbar sind.

In einer weiteren Ausgestaltung der Erfindung ist die Magnetbar oben im Freiraum oberhalb dessen Symmetrieachse fest stehend positioniert.

Die Magnetbar kann alternativ auch unten im Freiraum unterhalb dessen Symmetrieachse fest stehend oder seitlich im Freiraum seitlich von dessen Symmetrieachse fest stehend positioniert sein. Damit können die bekannten Sputterverfahren, Sputter-Up-, Sputter-Down- und Sputter-Side-Verfahren, oder auch schräg zur Horizontalen oder Vertikalen durch entsprechendes Verschwenken oder Anordnen der Magnetbar auf besonders einfach Weise realisiert werden.

In einer besonderen Variante der Erfindung sind im Freiraum zwei einander gegenüber liegende Magnetbars fest stehend angeordnet, derart, dass jeweils zwei Plasmawolken oben und unten vor dem jeweiligen Target ausgebildet werden. Damit kann das Sputter-Up- und das Sputter-Down-Verfahren gleichzeitig auf gleiche oder unterschiedliche Substrate angewendet werden.

Um eine bessere Ausnutzung der Targets zu ermöglichen, ist das polygonale Trägerrohr um die fest stehende Magnetbar in einer Pendelbewegung bewegbar.

In einer weiteren Fortführung der Erfindung ist die im Freiraum befindliche Magnetbar gegenüber dem polygonalen Trägerrohr in Winkelschritten verschwenkbar, so dass die für die verschiedenen Sputterverfahren notwendigen Positionen der Magnetbar besonders einfach einstellbar sind.

Schließlich ist das polygonale Trägerrohr über ein Anschlusselement mit einem handelsüblichen Magnetron-Endblock zum Drehantrieb des Trägerrohres, zur Energiezuführung sowie die Kühlwasserversorgung für die Magnetbar verbunden.

Das erfindungsgemäße Mehrfach-Sputtertarget kann zur Durchführung des Sputter-up-, des Sputter-side oder des Sputter-down-Verfahrens oder geneigt zur Horizontalen oder Vertikalen orientiert montiert zum Beschichten von Substraten gleichermaßen verwendet werden.

In einer besonderen Ausgestaltung der Erfindung sind zwei polygonale Trägerrohre mit jeweils in deren Freiraum befindlicher Magnetbar und auf deren Außenflächen befindlichen Targets mit gleichem oder unterschiedlichem Abstand zwischen magnetbar und zugehörigem Target in einer Bipolar-Anordnung parallel nebeneinander in einer gemeinsamen Vakuumkammer mit gemeinsamer MF-Stromversorgung angeordnet. Durch das einfache Positionieren von Targets aus unterschiedlichen Materialien, also indem beide polygonale Trägerrohre in Winkelschritten gedreht werden, bis die gewünschten Targets über der jeweiligen Magnetbar positioniert sind, lassen sich nahezu beliebige Materialkombinationen erzeugen.

In einer weiteren Fortführung der Erfindung sind ein polygonales Trägerrohr mit in einem Freiraum in diesem befindlicher Magnetbar und ein übliches Rohrmagnetron oder ein Planar-Magnetron in einer Bipolar-Anordnung parallel nebeneinander in einer gemeinsamen Vakuumkammer mit gemeinsamer MF-Stromversorgung angeordnet. Auch hier lässt sich eine Vielzahl von Materialkombinationen auf einem Substrat erzeugen, wobei auch Materialien einbezogen werden können, die eigentlich nur für Planar-Magnetrons verfügbar sind.

Mit dem in Winkelschritten drehbaren polygonalen Trägerrohr des Mehrfach-Sputtertargets können mit wesentlich weniger Aufwand mehrere unterschiedliche oder gleiche Materialien nacheinander gesputtert und auf einem Substrat abgeschieden werden können.

Zum Mehrfach-Sputtern werden zu diesem Zweck erfindungsgemäß anstelle der üblichen langestreckten Rohrtargets polygonale langgestreckte Trägerrohre mit einem eckigen Querschnitt verwendet, bei denen auf den längs verlaufenden Außenflächen Targets aus unterschiedlichen oder gleichen Materialien als Sputterquellen aufgebracht sind.

Die Befestigung der Targets auf den bevorzugt gleich großen Außenflächen der Trägerrohre, die während des Sputterns als Materialquellen für die auf einem Substrat aufzubringenden Beschichtungen dienen, kann mittels üblicher Klemmschienen (Pratzen) oder durch Aufbonden erfolgen.

Die Trägerrohre können eine Vielzahl von Querschnitten, wie ein Dreieck, ein Viereck, ein Fünfeck, ein Sechseck, Siebeneck oder auch Achteck aufweisen und mit einer entsprechenden Anzahl an Targets aus unterschiedlichen Materialien belegt werden. Auch Sonderformen, wie ein Trägerrohr mit einem drei- oder viereckigen Querschnitt und drei oder vier unterschiedlichen Targets sowie mit abgeschrägten Ecken sind möglich.

Vorteile der Erfindung:
- Es wird die Verwendung von unterschiedlichen oder gleichen Targetmaterialien in einem Beschichtungsprozess ermöglicht, ohne zwischendurch die Vakuumkammer wegen Targetwechsel oder Magnetronwechsel belüften zu müssen.
- Es sind auch Mehrfachbeschichtungen mit den gleichen Targetmaterialien möglich, was für eine Erhöhung der Standzeit der Anlage besonders vorteilhaft ist.
- Es ist die Verwendung von zwei, drei und bis zu acht Targets 2 aus unterschiedlichen Materialien auf dem polygonalen Trägerrohr 1 möglich.
- Es wird ein extrem geringer Platzbedarf erreicht.
- Die Targetmaterialien können durch einfaches Weiterdrehen des polygonalen Trägerrohres 1 in Winkelschritten "gewechselt" werden.
- Es kann ein Standard-Magnetfeld eines Rohrmagnetrons mit einer Standard-Magnetbar genutzt werden.
- Es wird nur eine Kühlung wie bei einem Rohrmagnetron benötigt.
- Es kann ein Standard Rohrtarget Endblock als Aufnahme und Antrieb für das polygonale Trägerrohr genutzt werden.
- Es wird nur eine Energiezuführung benötigt.
- Das Target kann zusammen mit bereits existierenden Standard Endblöcken und Standard-Magnetbars von typischen Rohrkathoden-Sputterquellen genutzt werden.
- Bei der Verwendung von Bipolar Anordnungen ergeben sich vielfältige Material-Misch-Möglichkeiten.
- Es ist möglich, lange Maschinenstandzeiten zu erreichen, wenn z.B. gleiche Targets montiert werden und immer das durchgesputterte Target weitergedreht wird.
- Es wird eine hohe Flexibilität für Beschichtungen mit verschiedenen Materialien ermöglicht.
- Die Investitionskosten für den Kunden sind vergleichsweise gering, weil die erfindungsgemäßen Mehrfachtargets auch in bestehenden Rohrmagnetron Systemen eingesetzt werden können.
- Es ist problemlos möglich, die erfindungsgemäßen Mehrfach Sputtertargets zusammen mit üblichen Rohr- oder Planartargets in einer parallel nebeneinander befindlichen Anordnung mit gemeinsamer MF-Stromversorgung einzusetzen, was zu einer größeren Flexibilität der Anlage führt.

Die Erfindung wird nachfolgend an einigen Ausführungsbeispielen näher erläutert.

Die Zeichnungsfiguren zeigen in
- Fig. 1:: ein Mehrfach-Sputtertarget aus einem polygonalen Trägerrohr im Querschnitt mit einem in Winkelschritten drehbaren Dreifach-Targetsystem auf den Außenflächen und mit einer Magnetbar innerhalb des Trägerrohres mit drei Targets und angedeuteten Plasmawolken vor dem jeweils oben befindlichen Target, sowie ein oberhalb der Plasmawolken vorbeigeführtes Substrat;
- Fig. 2a:: ein Mehrfach-Sputtertarget mit einem polygonalen Trägerrohr wie in Fig. 1, jedoch als Vierfach-Targetsystem mit vier Targets;
- Fig. 2b:: ein Mehrfach-Sputtertarget mit einem polygonalen Trägerrohr wie in Fig. 1 mit Vierfach-Targetsystem, jedoch mit abgeschrägten Kanten;
- Fig. 3:: ein Mehrfach-Sputtertarget mit einem polygonalen Trägerrohr wie in Fig. 1 mit einem Penta-Targetsystem;
- Fig. 4:: ein Mehrfach-Sputtertarget mit einem polygonalen Trägerrohr wie in Fig. 1 mit einem Hexa-Targetsystem;
- Fig. 5:: ein Mehrfach-Sputtertarget mit einem polygonalen Trägerrohr wie in Fig. 1 mit einem Okta-Targetsystem;
- Fig. 6:: eine schematische Seitenansicht eines an einem Endblock montierten polygonalen Trägerrohres eines Mehrfach-Sputtertargets;
- Fig. 7:: ein Mehrfach-Sputtertarget mit einem polygonalen Trägerrohr, in dem eine Magnetbar im unteren Bereich des Freiraumes positioniert ist;
- Fig. 8:: ein Mehrfach-Sputtertarget mit einem polygonalen Trägerrohr, in dem eine Magnetbar seitlich im Freiraum positioniert ist;
- Fig. 9:: ein Mehrfach-Sputtertarget mit einem polygonalen Trägerrohr, in dem zwei Magnetbars zeichnungsgemäß jeweils oben und unten im Freiraum positioniert sind, so dass oben und unten jeweils zwei Plasmawolken vor den entsprechenden Targets ausgebildet werden, an den jeweils ein Substrat vorbeigeführt werden kann;
- Fig. 10:: eine Parallelanordnung von zwei Mehrfach-Sputtertargets mit gemeinsamer MF-Stromversorgung zur Abscheidung gleicher Materialien auf einem Substrat;
- Fig. 11:: eine Parallelanordnung von zwei Mehrfach-Sputtertargets mit gemeinsamer MF-Stromversorgung zur Abscheidung von unterschiedlichen Materialien auf einem Substrat;
- Fig. 12:: eine Parallelanordnung von einem Mehrfach-Sputtertarget und einem Rohrmagnetron mit gemeinsamer MF-Stromversorgung zur Abscheidung von verschiedenen Materialien auf einem Substrat; und
- Fig. 13:: eine Parallelanordnung von zwei Vierfach-Sputtertargets in symmetrischer und asymmetrischer Ausführung mit unterschiedlichem Abstand zwischen Magnetbar und Target.

Das besondere an der Erfindung ist, dass das Mehrfach-Sputtertarget in Form eines polygonalen Trägerrohres 1 mit mehreren Außenflächen 3 zur Aufnahme von Targets 2 ausgestattet ist, wobei sich innerhalb des polygonalen Trägerrohres 1 eine Magnetbar 4 in einem Freiraum 5 befindet. Der Freiraum 5 erstreckt sich längs durch das Zentrum des Trägerrohres 1 und hat bevorzugt einen kreisringförmigen Querschnitt.

Es versteht sich, dass die nachfolgend beschriebenen Beschichtungen mit den verschiedenen Varianten des Mehrfach-Sputtertargets mit dem polygonalen Trägerrohr 1 unter Vakuum in einer nicht dargestellten Vakuumkammer hergestellt werden müssen.

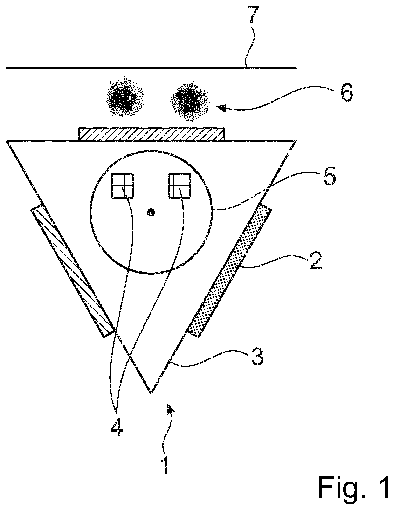

In Fig. 1 ist ein polygonales Trägerrohr 1 eines Mehrfach-Sputtertargets mit einem in Winkelschritten drehbaren Dreifach-Targetsystem mit drei Targets 2 dargestellt, die einzeln jeweils auf einer Außenfläche 3 des Trägerrohres 1 mit dreieckigem Querschnitt befestigt sind, wobei die Targets 2 aus dem gleichen, oder bevorzugt aus unterschiedlichen Materialien bestehen können.

Innerhalb des Trägerrohres 1 befindet sich die räumlich feststehende Magnetbar 4, die oben im Freiraum 5, d.h. oberhalb dessen Symmetrieachse, positioniert ist. Mit der Magnetbar 4 werden zwei Plasmawolken 6 vor dem jeweils oben auf dem Trägerrohr 1 befindlichen Target 2 erzeugt, mit deren Hilfe ein oberhalb der Plasmawolken 6 befindliches, oder vorbeigeführtes Substrat 7 mit dem vom Target 2 abgesputterten Material im Sputter-Up-Verfahren beschichtet wird.

Das Sputter-Up-verfahren hat bekanntlich den Vorteil, dass hauptsächlich nach oben beschleunigte abgesputterte Teilchen auf dem Substrat 7 abgeschieden werden.

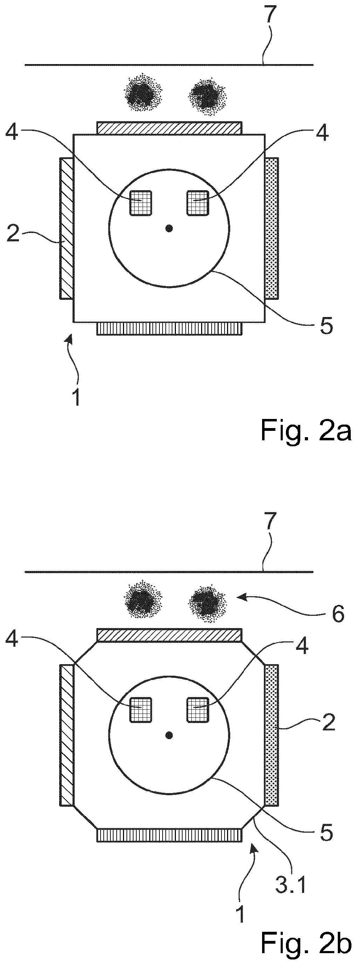

Fig. 2a zeigt ein polygonales Trägerrohr 1 mit quadratischem Querschnitt mit vier längs verlaufenden Außenflächen 3 auf denen jeweils ein Target 2 befestigt ist. Im Freiraum 5 befindet sich die Magnetbar 4 oberhalb dessen Symmetrieachse.

In Fig. 2b ist ein Mehrfach-Sputtertarget mit einem polygonalen Trägerrohr 1 mit einem ähnlichen Aufbau wie in Fig. 1, 2a, jedoch mit vier längs verlaufenden Außenflächen 3 mit abgeschrägten Kanten 3.1 des polygonalen Trägerrohres 1 dargestellt.

Derartige abgeschrägte Kanten sind grundsätzlich auch bei einem Dreifach-Targetsystem nach Fig. 1 realisierbar.

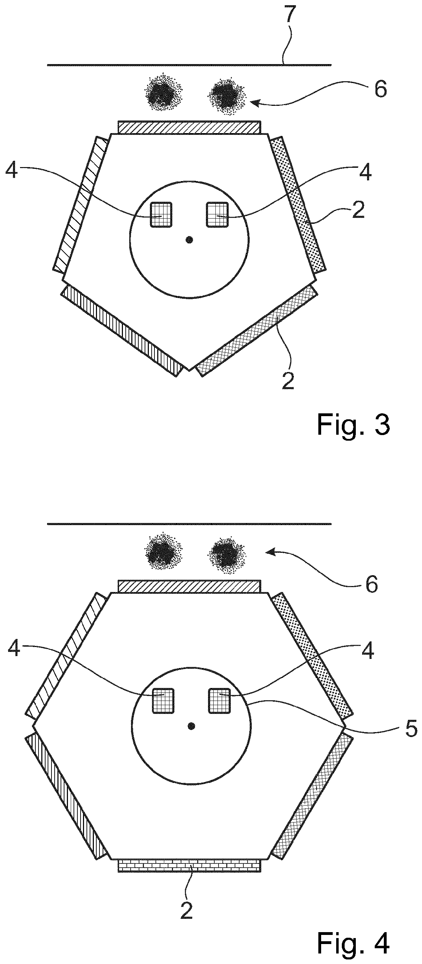

Die Fig. 3 zeigt ein Mehrfach-Sputtertarget mit einem polygonalen Trägerrohr 1 mit einem Aufbau wie in Fig. 1, jedoch als Penta-Targetsystem mit fünf längs verlaufenden Außenflächen 3 des Trägerrohres 1 zur Aufnahme von maximal fünf Targets 2.

Weiterhin zeigt Fig. 4 ein Mehrfach-Sputtertarget mit einem polygonalen Trägerrohr 1 mit einem Aufbau wie in Fig. 1, jedoch mit einem Hexa-Targetsystem mit sechs längs verlaufenden Außenflächen 3 zur Aufnahme von insgesamt sechs Targets 2.

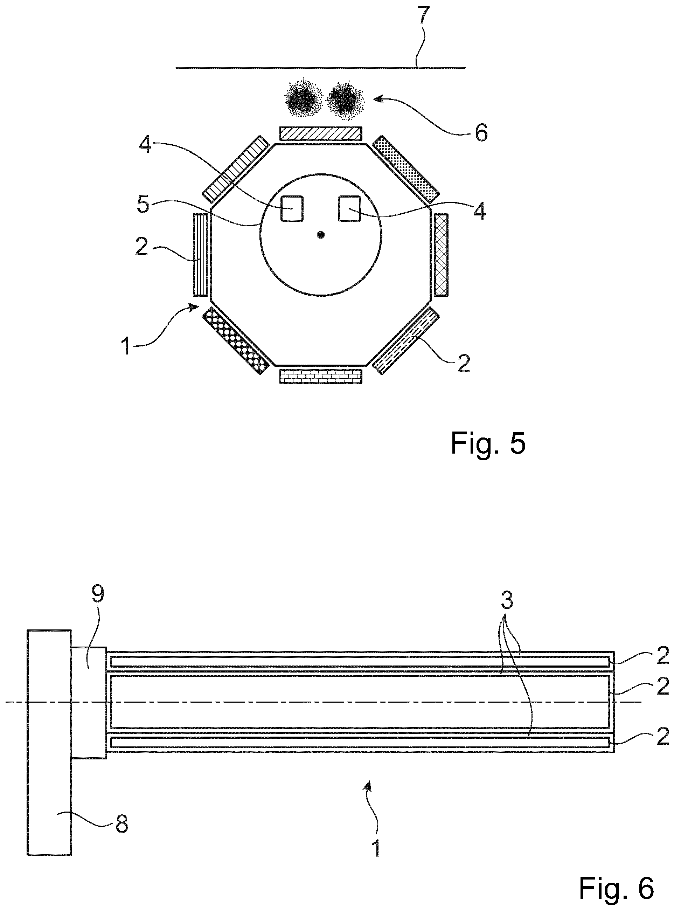

Fig. 5 zeigt ein Mehrfach-Sputtertarget mit einem polygonalen Trägerrohr 1 mit einem Aufbau wie in Fig. 1, jedoch mit einem Okta-Targetsystem mit acht längs verlaufenden Außenflächen 3 zur Aufnahme von jeweils einem Target 2.

Bei den meisten vorstehend beschriebenen Varianten befindet sich die Magnetbar 4 im Freiraum 5 oberhalb dessen Symmetrieachse, wobei sich der Freiraum 5 zentral durch das Trägerrohr 1 erstreckt.

Eine Ausnahme von dieser Positionierung kann dann sinnvoll sein, wenn das polygonale Trägerrohr 1 einen besonders großen Durchmesser aufweist, um zu vermeiden, dass der Abstand zwischen der Magnetbar 4 im polygonalen Trägerrohr 1 und dem Target 2 auf der Außenfläche 3 des Trägerrohres 1 zu groß wird und dadurch die Intensität der Plasmawolken 7 geschwächt würde. In diesem Fall sollte der genannte Abstand verringert werden.

Die unterschiedlichen Schraffuren der auf den Außenflächen 3 des Trägerrohres 1 befestigten Targets 2 sollen jeweils unterschiedliche Materialien symbolisieren. Zur Auswahl des abzusputternden Materials muss das Trägerrohr 1 lediglich in gleichen Winkelschritten gedreht werden, bis das gewünschte Target 2 oben über der Magnetbar 4 positioniert ist. Die benötigten Plasmawolken 6 entstehen dann beim Betrieb der Magnetbar 4 vor dem oben befindlichen Target 2.

Die polygonalen Trägerrohre 1 mit unterschiedlichem Querschnitt können mit einem handelsüblichen Magnetron-Endblock 8 über ein Anschlusselement 9 betrieben werden, wobei im Inneren des Trägerrohres 1 eine räumlich feststehende Magnetbar 4 eines üblichen Rohrtargets zum Einsatz kommen kann. Fig. 6 zeigt eine Seitenansicht eines hexagonalen Trägerrohres 1 mit den auf den Außenflächen 3 befindlichen Targets 2.

Besonders lange Trägerrohre 1 können mit ihrem freien Ende in einem nicht dargestellten Gegenlager gelagert werden, um Durchbiegungen auf ein Minimum zu beschränken.

Das zum Sputtern erforderliche Sputterplasma wird aufgrund des Magnetfeldes durch die Magnetbar 4 in der Nähe der Targetoberfläche erzeugt. Durch Drehen des Trägerrohres 1 mit den darauf befindlichen Targets 2 können somit nacheinander gegenüber der Magnetbar 3 unterschiedliche oder gleiche Materialien - je nachdem wie die Targets 2 auf Außenflächen 3 des Trägerrohres 1 verteilt sind - abgesputtert und ein vorbeigeführtes Substrat 7 entsprechend beschichtet werden. Zusätzlich kann eine Pendelbewegung des polygonalen Trägerrohres 1 oder der Magnetbar 4 ein erweitertes Targetabtragungsfeld erzielen, wodurch eine bessere Nutzung der Targets 2 erreicht wird.

In den Zeichnungsfiguren Fig. 1 bis Fig. 5 ist die erfindungsgemäße Sputtervorrichtung zum Betrieb im sputter-up-Verfahren dargestellt. Das bedeutet, dass sich die vom Target 2 abgesputterten Teilchen sich nach oben in Richtung zu dem über den Plasmawolken 6 vorbei bewegten zu beschichtenden Substrat 7 bewegen.

Andere Sputterverfahren, wie das Sputter-Down-Verfahren, lassen sich mit dem Mehrfach-Sputtertarget in Verbindung mit dem oben beschriebenen polygonen Trägerrohr 1 einfach dadurch realisieren, indem die Magnetbar 4 um 180° um eine imaginäre Schwenkachse nach unten geschwenkt wird, so dass sich die Magnetbar 4 unterhalb der Symmetrieachse des Freiraumes 5 befindet. Alternativ ist die Magnetbar 4 im Freiraum 5 nach unten gerichtet zu positionieren, so dass sich die Plasmawolken 6 vor einem sich unten auf dem Trägerrohr 1 befindlichen Target 2 ausbilden.

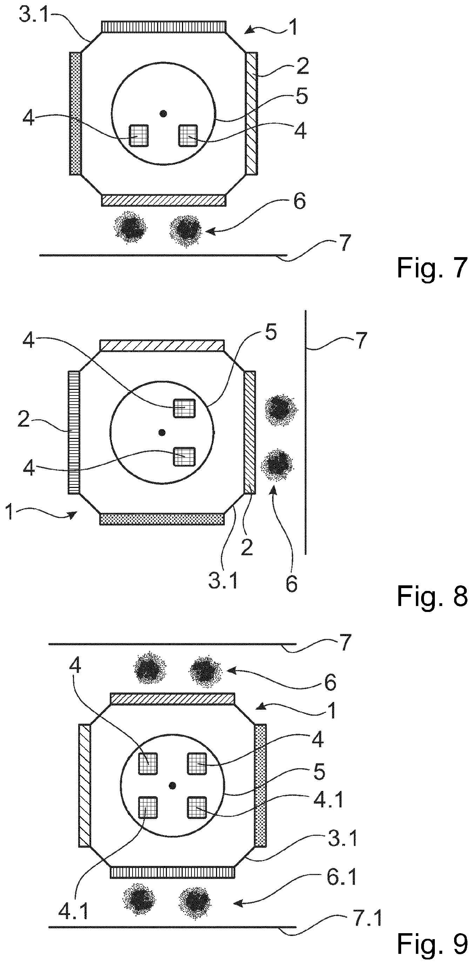

Die vom Target 2 abgesputterten Teilchen werden in diesem Fall auf einem unterhalb der Plasmawolken 6 vorbeigeführten zu beschichtenden Substrat 7 abgeschieden. (Fig. 7)

Soll ein Sputter-Side-Verfahren, also eine seitliche Abscheidung auf einem Substrat 7, realisiert werden, so wäre die Magnetbar 4 um 90° in eine seitliche Position zu bringen, so dass die Plasmawolken 6 sich vor dem seitlich zu positionierenden Target 2 ausbilden. Das zu beschichtende Substrat 7 wäre in diesem Fall seitlich senkrecht vor den Plasmawolken 6 zu positionieren oder vorbeizuführen. (Fig. 8)

Eine besondere Ausgestaltung der Erfindung ist in Fig. 9 dargestellt. Das beschriebene polygonale Trägerrohr 1 ist hier mit einem zentralen Freiraum 5 ausgestattet, in dem zwei Magnetbars 4, 4.1 jeweils ober- und unterhalb der Symmetrieachse angeordnet sind. Auf diese Weise können oben und unten vor den entsprechenden Targets 2 jeweils zwei Plasmawolken 6, 6.1 ausgebildet werden, an den jeweils ein Substrat 7, 7.1 vorbeigeführt, oder positioniert werden kann. Voraussetzung für diese Ausgestaltung der Erfindung ist, dass das polygonale Trägerrohr 1 eine geradzahlige Anzahl von Außenflächen 3 hat.

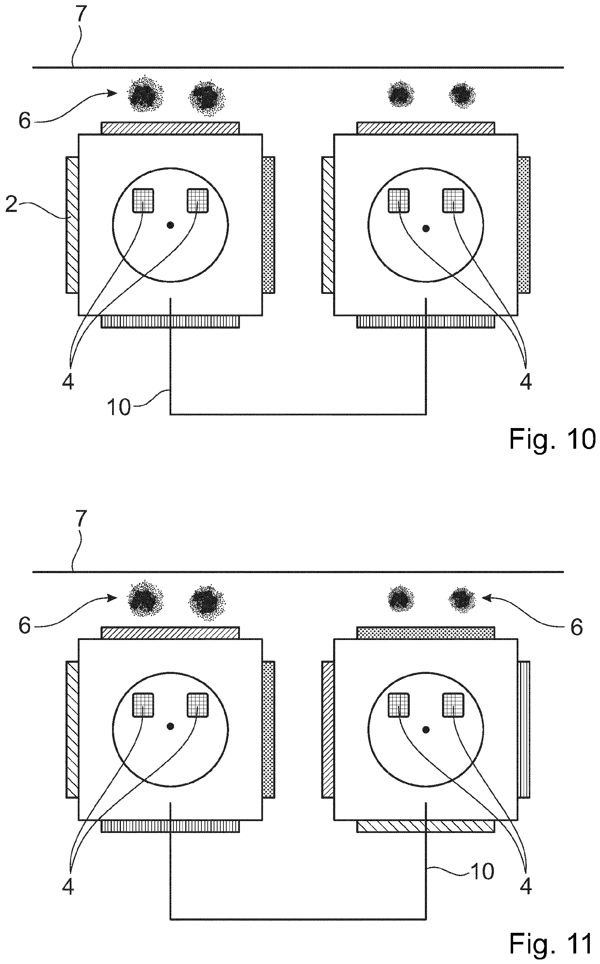

In den Fig. 10 bis 11 sind besondere Ausführungsformen mit Mehrfach-Sputtertargets oder in Kombination mit einem konventionellen Rohrmagnetron dargestellt, um einen Bipolar-Prozess in einer gemeinsamen Vakuumkammer durchführen zu können. Dadurch wird die Flexibilität einer Sputteranlage wesentlich erhöht.

Eine Parallelanordnung von zwei erfindungsgemäßen Mehrfach-Sputtertargets mit gemeinsamer MF-Stromversorgung 10 zur Abscheidung gleicher Materialien auf einem Substrat 7 ist in Fig. 10 dargestellt.

Fig. 11 zeigt im Grunde genommen die gleiche Parallelanordnung von zwei Mehrfach-Sputtertargets mit gemeinsamer MF-Stromversorgung zur Abscheidung von unterschiedlichen Materialien auf einem Substrat, wobei hier das zeichnungsgemäß rechte polygonale Trägerrohr 1 mit einem anderen Target 2 nach oben in die Beschichtungsposition gedreht ist. Das erlaubt die Abscheidung von verschiedenen Materialkombinationen auf einem Substrat 7.

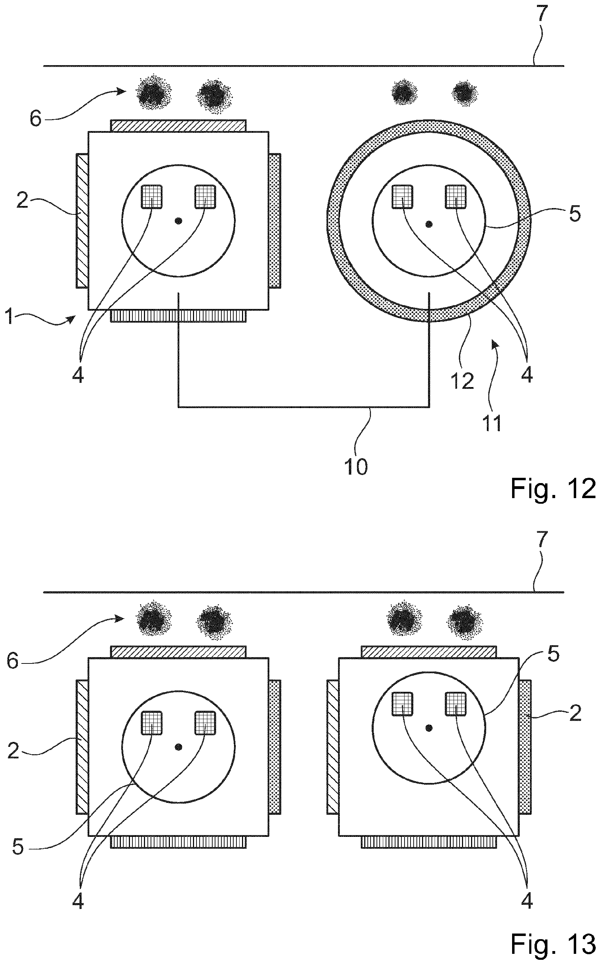

Eine besondere Variante zeigt Fig. 12 mit einer gleichzeitig betriebenen Parallelanordnung von einem erfindungsgemäßen Mehrfach-Sputtertarget und einem üblichen Rohrmagnetron 11 mit gemeinsamer MF-Stromversorgung 10 zur Abscheidung von verschiedenen Materialien auf einem Substrat 7. Das Rohrmagnetron 11 enthält einen zentralen Freiraum 5, in dem sich eine Magnetbar 4 befindet und das von einem Rohrtarget 12 umgeben wird.

Schließlich zeigt Fig. 13 eine Parallelanordnung von zwei Mehrfach-Sputtertargets mit gemeinsamer MF-Stromversorgung zur Abscheidung von gleichen Materialien auf einem Substrat 7 mit jeweils einem polygonalen Trägerrohr 1 und im Freiraum 5 befindlicher Magnetbar 4, wobei das zeichnungsgemäß linke Mehrfach-Sputtertarget symmetrisch und das zeichnungsgemäß rechte Mehrfach-Sputtertarget asymmetrisch ausgeführt ist. Dadurch lassen sich unterschiedliche Abstände zwischen Magnetbar 4 und Target 2 realisieren. Dadurch kann mit unterschiedlich starkem Magnetfeld gesputtert werden.

Auch ist eine Kombination eines erfindungsgemäßen Mehrfach-Sputtertargets mit einem üblichen Planarmagnetron (nicht dargestellt) und mit gemeinsamer MF-Stromversorgung in einer gemeinsamen Vakuumkammer problemlos möglich. Auch mit dieser Kombination ist die Abscheidung von Materialkombinationen auf dem vorbeizuführenden Substrat möglich.

Anstelle der in den Fig. 7 - 9 dargestellten polygonalen Trägerrohre mit vier Außenflächen 3 und abgeschrägten Kanten 3.1 können die polygonalen Trägerrohre 1 auch die in den anderen Zeichnungsfiguren dargestellten Querschnittsformen aufweisen.

Der Vorteil dieser Ausgestaltung des Mehrfach-Sputtertargets erlaubt es, Sputter-Up- und Sputter-Down-Verfahren gleichzeitig auszuführen.

Als Magnetbars 4 können Standard-Magnetbars oder auch beliebig andere geeignete Magnetbars im Freiraum 5 verwendet werden.

Die für den Betrieb an einem Magnetron-Endblock 8 und im Stützlager erforderlichen runden Anschlusselemente 9 können durch Schweißen an das Trägerrohr 1 angefügt werden, oder es wird ein entsprechendes Anschlusselement 9 als Adapter verwendet. (Fig. 6)

Anstelle des handelsüblichen Magnetron-Endblockes 7 können auch andere geeignete Aufnahmevorrichtungen mit Verstellmotoren verwendet werden, vorausgesetzt, es wird eine winkelgenaue Drehbewegung erzeugt, um die verschiedenen Targets 2 auf dem polygonalen Trägerrohr 1 in die richtige Position, d.h. parallel zum zu beschichtenden Substrat 7, 7.1 zu bringen.

Auch eine Pendelbewegung des polygonalen Trägerrohres 1 des Mehrfachtargets um die feststehende Magnetbar ist denkbar.

### Bezugszeichenliste

- 1: Trägerrohr
- 2: Target
- 3: Außenfläche
- 3.1: abgeschrägte Kante
- 4: Magnetbar
- 4.1: Magnetbar
- 5: Freiraum
- 6: Plasmawolke
- 6.1: Plasmawolke
- 7: Substrat
- 7.1: Substrat
- 8: Magnetron-Endblock
- 9: Anschlusselement
- 10: MF-Stromversorgung
- 11: Rohrmagnetron
- 12: Rohrtarget

## Patentansprüche

1. Mehrfach-Sputtertarget für Magnetronanordnungen mit Rohrmagnetrons, zum Beschichten von ruhenden, oder längs oder auf einer Kreisbahn durch eine Vakuumkammer transportierten Substraten, wobei das Rohrmagnetron in einem Endblock, oder einer anderweitigen Antriebseinheit, gelagert ist und wobei sich in dem Rohrmagnetron eine Magnetbar befindet, **dadurch gekennzeichnet, dass** mindestens ein polygonales Trägerrohr (1) mit einem eckigen Querschnitt vorgesehen ist, das eine Mehrzahl von längs verlaufenden Außenflächen (3) zur Aufnahme von Targets (2) aufweist, dass sich in dem mindestens einen polygonalen Trägerrohr (1) ein Freiraum (5) befindet, der sich längs durch dieses erstreckt und in dem sich eine Magnetbar (4) zur Ausbildung von Plasmawolken (6) außerhalb des polygonalen Trägerrohres (1) in einer Arbeitsposition vor einem durch Drehen des polygonalen Trägerrohres auswählbaren Target (2) befindet und dass sich das bewegte oder ruhende Substrat (7) in einem vorgegebenen Abstand vor den Plasmawolken (6) befindet.

2. Mehrfach-Sputtertarget nach Anspruch 1, **dadurch gekennzeichnet, dass** sich auf jeder der Außenflächen (3) des polygonalen Trägerrohres (1) ein Target (2) befindet, wobei die Targets (2) aus gleichen oder unterschiedlichen Materialien bestehen.

3. Mehrfach-Sputtertarget nach einem der Ansprüche 1 oder 2, **dadurch gekennzeichnet, dass** das polygonale Trägerrohr (1) einen dreieckigen, viereckigen, fünfeckigen, sechseckigen, siebeneckigen oder achteckigen Querschnitt aufweist.

4. Mehrfach-Sputtertarget nach einem der Ansprüche 1 bis 3, **dadurch gekennzeichnet, dass** das polygonale Trägerrohr (1) in Winkelschritten drehbar ist, derart, dass die Targets (2) einzeln zwischen der Magnetbar (4) und den vor dieser befindlichen Plasmawolke (6) positionierbar sind.

5. Mehrfach-Sputtertarget nach einem der Ansprüche 1 bis 4, **dadurch gekennzeichnet, dass** die Magnetbar (4) oben im Freiraum (5) oberhalb dessen Symmetrieachse fest stehend positioniert ist.

6. Mehrfach-Sputtertarget nach einem der Ansprüche 1 bis 4, **dadurch gekennzeichnet, dass** die Magnetbar (4) unten im Freiraum (4) unterhalb dessen Symmetrieachse fest stehend positioniert ist.

7. Mehrfach-Sputtertarget nach einem der Ansprüche 1 bis 4, **dadurch gekennzeichnet, dass** die Magnetbar (4) seitlich im Freiraum (5) seitlich von dessen Symmetrieachse fest stehend positioniert ist.

8. Mehrfach-Sputtertarget nach einem der Ansprüche 1 bis 4, **dadurch gekennzeichnet, dass** im Freiraum (5) zwei einander gegenüber befindliche Magnetbars (4, 4,1) fest stehend angeordnet sind, derart, dass jeweils Plasmawolken (6, 6.1) oben und unten vor dem jeweiligen Target (2) befinden.

9. Mehrfach-Sputtertarget nach einem der Ansprüche 1 bis 8, **dadurch gekennzeichnet, dass** das polygonale Trägerrohr (1) um die fest stehende Magnetbar (4) in einer Pendelbewegung bewegbar ist.

10. Mehrfach-Sputtertarget nach einem der Ansprüche 1 bis 4, **dadurch gekennzeichnet, dass** die Magnetbar (4) im Freiraum (5) um eine virtuelle Achse gegenüber dem polygonalen Trägerrohr (1) in beliebigen Winkelschritten verschwenkbar ist.

11. Mehrfach-Sputtertarget nach einem der vorhergehenden Ansprüche, **dadurch gekennzeichnet, dass** das polygonale Trägerrohr (1) über ein Anschlusselement (9) mit einem handelsüblichen Magnetron-Endblock (8) zum Drehantrieb des Trägerrohres (1) sowie zur Energiezuführung sowie zur Kühlwasserzuführung für die Magnetbar (4) verbunden ist.

12. Verwendung des Mehrfach-Sputtertargets nach den Ansprüchen 1 bis 11 zur Durchführung des Sputter-up-, des Sputter-side oder des Sputter-down-Verfahrens zum Beschichten von Substraten.

13. Mehrfach-Sputtertarget nach einem der vorhergehenden Ansprüche 1 bis 11, **dadurch gekennzeichnet, dass** zwei polygonale Trägerrohre (1) mit im Freiraum (5) befindlicher Magnetbar (4) und auf den Außenflächen (3) befindlichen Targets (2) mit gleichem oder unterschiedlichem Abstand zwischen der Magnetbar (4) und zugehörigem Target (2) in einer Bipolar-Anordnung parallel nebeneinander in einer gemeinsamen Vakuumkammer mit gemeinsamer MF-Stromversorgung (10) angeordnet sind.

14. Mehrfach-Sputtertarget nach einem der vorhergehenden Ansprüche 1 bis 11, **dadurch gekennzeichnet, dass** ein polygonales Trägerrohr (1) mit im Freiraum (5) befindlicher Magnetbar (4) und ein Rohrmagnetron (11) oder ein Planar-Magnetron in einer Bipolar-Anordnung parallel nebeneinander in einer gemeinsamen Vakuumkammer mit gemeinsamer MF-Stromversorgung (10) angeordnet sind.
